# EUROPEAN PATENT APPLICATION

(11) **EP 3 550 316 A1**
(43) Date of publication of application: **09.10.2019**
(21) Application number: 17877098.8
(22) Date of filing: 21.11.2017
(51) Int. Cl.: G01R 31/36, H01M 10/44, H01M 10/48, H02J 7/00

(54) **SCREENING METHOD, SCREENING DEVICE, AND METHOD FOR MANUFACTURING SECONDARY BATTERY**

(30) Priority: 30.11.2016 JP 2016232479
(71) Applicant: Kabushiki Kaisha Nihon Micronics, Musashino-shi, Tokyo 180-8508 (JP)
(72) Inventor: SANO Masami, Musashino-shi Tokyo 180-8508 (JP); UEKI Isao, Musashino-shi Tokyo 180-8508 (JP); IGARASHI Masayuki, Musashino-shi Tokyo 180-8508 (JP)
(74) Representative: Guérin, Jean-Philippe
(86) International application number: PCT/JP2017/041744
(87) International publication number: WO 2018/101114

(57) **Abstract**

A screening method according to the present invention is a screening method for screening a sheet-type battery (21), including a charging/discharging waveform acquisition step (S11) of acquiring a charging/discharging waveform of the sheet-type battery (21) by charging and discharging the sheet-type battery (21), a step (S12) of evaluating a variation in discharging voltage over time during discharging in the sheet-type battery based on the charging/discharging waveform, a step (S13) of evaluating a variation in charging voltage over time during charging in the sheet-type battery based on the charging/discharging waveform, a step (S14) of evaluating charging efficiency of the sheet-type battery based on the charging/discharging waveform, a step (S15) of evaluating a current value at an end of the charging the sheet-type battery based on the charging/discharging waveform, and a screening step (S16) of screening the sheet-type battery (21) based on evaluation results of the steps (S12 to S15).

## Description

### Technical Field

The present invention relates to a technique for screening unit batteries.

### Background Art

Patent Literatures 1 to 3 disclose secondary batteries. Each of the secondary batteries disclosed in Patent Literatures 1 to 3 has a laminated structure in which a first electrode, an n-type metal oxide semiconductor layer, a charging layer, a p-type metal oxide semiconductor layer, and a second electrode are laminated on a substrate.

### Citation List

### Patent Literature

Patent Literature 1: International Patent Publication No. 2013/065093
Patent Literature 2: International Patent Publication No. 2013/161926
Patent Literature 3: International Patent Publication No. 2013/161927

### Summary of Invention

### Technical Problem

Further, Patent Literatures 2 and 3 disclose that a plurality of batteries are used while combining them with one another. For example, in Patent Literatures 2 and 3, a battery having a required capacity is manufactured by laminating sheet-type batteries.

When a plurality of sheet-type batteries are combined with one another, a plurality of sheet-type batteries, which are prepared to be combined with one another, are screened (i.e., sorted out) and, for example, only those having a certain capacity or larger are actually laminated so that variations in capacity among the combined batteries is reduced. Therefore, it is desired to develop a technique in which a secondary battery is manufactured after appropriately screening sheet-type batteries.

The embodiment has been made in view of the above-described problem and an object thereof is to provide a screening method, a screening apparatus, and a method for manufacturing a secondary battery capable of appropriately screening sheet-type batteries.

### Solution to Problem

A screening method according to an embodiment is a screening method for screening a unit battery, including: a charging/discharging waveform acquisition step of acquiring a charging/discharging waveform of the unit battery by charging and discharging the unit battery; a first step of evaluating a variation in discharging voltage over time during discharging in the unit battery based on the charging/discharging waveform; a second step of evaluating a variation in charging voltage over time during charging in the unit battery based on the charging/discharging waveform; a third step of evaluating charging efficiency of the unit battery based on the charging/discharging waveform; a fourth step of evaluating a current value at an end of the charging of the unit battery based on the charging/discharging waveform; and a screening step of screening the unit battery based on evaluation results of the first, second, third and fourth steps.

In the above-described screening method, in the charging/discharging waveform acquisition step, the charging/discharging waveform may be acquired by charging the unit battery for a predetermined time in a CC-CV (Constant Current-Constant Voltage) manner and then discharging the unit battery in a CC (Constant Current) manner.

In the above-described screening method, in the first step, the variation in discharging voltage over time during the discharging may be evaluated based on whether or not the variation in discharging voltage over time is equal to or higher than a predetermined discharging voltage threshold.

In the above-described screening method, in the second step, the variation in charging voltage over time during the charging may be evaluated based on whether or not the variation in charging voltage over time is equal to or higher than a predetermined charging voltage threshold.

In the above-described screening method, in the fourth step, the current value at the end of the charging may be evaluated based on whether or not the current value at the end of the charging is equal to or higher than a predetermined current threshold.

In the above-described screening method, the charging/discharging waveform may be acquired again for the unit battery for which the evaluations in the first, second, third and fourth steps are satisfactory, a variation in discharging time among a plurality of charging/discharging waveforms for the unit battery may be evaluated, and the unit battery may be screened based on a result of the evaluation of the variation in discharging time.

A method for manufacturing a secondary battery according to an embodiment is a method for manufacturing a secondary battery by connecting a plurality of unit batteries with one another, the plurality of unit batteries being screened by the above-described screening method.

A screening apparatus according to an embodiment is a screening apparatus configured to screen a unit battery, including: a charger/discharger configured to charge and discharge the unit battery; a charging/discharging waveform acquisition unit configured to acquire a charging/discharging waveform of the unit battery by charging and discharging the unit battery by the charger/discharger; a discharging voltage evaluation unit configured to evaluate a variation in discharging voltage over time during discharging in the unit battery based on the charging/discharging waveform; a charging voltage evaluation unit configured to evaluate a variation in charging voltage over time during charging in the unit battery based on the charging/discharging waveform; a charging efficiency evaluation unit configured to evaluate charging efficiency of the unit battery based on the charging/discharging waveform; and a current value evaluation unit configured to evaluate a current value at an end of the charging of the unit battery based on the charging/discharging waveform.

In the above-described screening apparatus, the charging/discharging waveform acquisition unit may acquire the charging/discharging waveform by charging, by the charger/discharger, the unit battery for a predetermined time in a CC-CV manner and then discharging the unit battery in a CC manner.

In the above-described screening apparatus, the discharging voltage evaluation unit may evaluate the variation in discharging voltage over time during the discharging based on whether or not the variation in discharging voltage over time is equal to or higher than a predetermined discharging voltage threshold.

In the above-described screening apparatus, the charging voltage evaluation unit may evaluate the variation in charging voltage over time during the charging based on whether or not the variation in charging voltage over time is equal to or higher than a predetermined charging voltage threshold.

In the above-described screening apparatus, the current value evaluation unit may evaluate the current value at the end of the charging based on whether or not the current value at the end of the charging is equal to or higher than a predetermined current threshold.

In the above-described screening apparatus, for the unit battery for which the evaluations in the discharging voltage evaluation unit, the charging voltage evaluation unit, the charging efficiency evaluation unit, and the current value evaluation unit are satisfactory, the charging/discharging waveform acquisition unit may acquire the charging/discharging waveform again by charging and discharging, by the charger/discharger, that unit battery, a variation in discharging time among a plurality of charging/discharging waveforms for the unit battery may be evaluated, and the unit battery may be screened based on a result of the evaluation of the variation in discharging time.

### Advantageous Effects of Invention

An object is to provide a screening method, a screening apparatus, and a method for manufacturing a secondary battery capable of appropriately screening sheet-type batteries.

### Brief Description of Drawings

Fig. 1 shows a sheet-type battery and a screening apparatus therefor according to an embodiment;
Fig. 2 is a block diagram showing a control configuration of a personal computer of the screening apparatus;
Fig. 3 is a flowchart showing a screening method according to the embodiment;
Fig. 4 is a graph showing charging/discharging waveforms for explaining an evaluation of a discharging voltage;
Fig. 5 is a graph showing charging/discharging waveforms for explaining an evaluation of a charging voltage;
Fig. 6 is a graph showing charging/discharging waveforms for explaining an evaluation of charging/discharging efficiency;
Fig. 7 is a graph showing charging/discharging waveforms for explaining an evaluation of a charging current;
Fig. 8 is a graph showing charging/discharging waveforms for explaining variations in discharging time;
Fig. 9 is a graph showing charging/discharging waveforms for explaining variations in discharging time;
Fig. 10 shows a screen through which a threshold for an evaluation is entered; and
Fig. 11 shows a secondary battery manufactured by combining sheet-type batteries with one another.

### Description of Embodiments

Embodiments according to the present invention are explained hereinafter with reference to the drawings. The following descriptions are given for showing preferred embodiments according to the present invention, and the scope of the present invention should not be limited to the below-shown embodiments. In the following descriptions, components/structures to which the same symbols are assigned are substantially equivalent to each other.

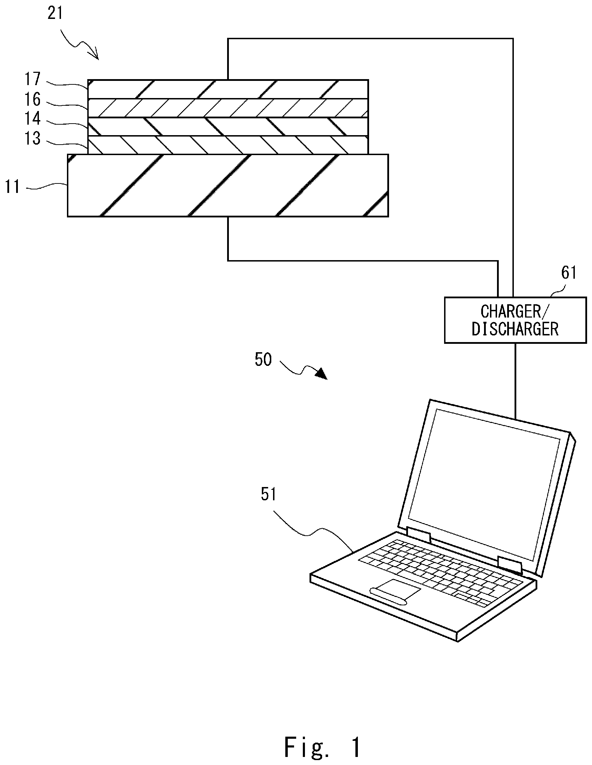

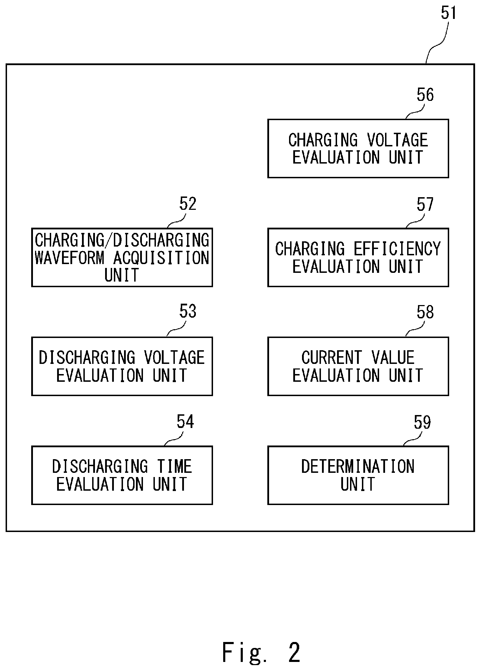

A secondary battery and its screening apparatus according to this embodiment will be described with reference to Figs. 1 and 2. Fig. 1 shows a configuration of a sheet-type battery 21 and its screening apparatus 50. Fig. 2 is a block diagram showing a control configuration of a personal computer 51 of the screening apparatus 50.

The screening apparatus 50 performs a screening by carrying out a charging/discharging test on the sheet-type battery 21 which serves as a unit cell. Specifically, the same charging/discharging test is carried out on a plurality of sheet-type batteries 21. Then, it is determined whether or not a result of the charging/discharging test carried out on each sheet-type battery 21 satisfies a predetermined condition. Then, based on the result of the charging/discharging test, pass/fail of each sheet-type battery 21 is determined.

For example, the screening apparatus 50 obtains a charging/discharging waveform of each sheet-type battery 21 by carrying out a charging/discharging test on each sheet-type battery 21. The screening apparatus 50 determines a sheet-type battery whose acquired charging/discharging waveform satisfies the predetermined condition to be of good quality and a sheet-type battery 21 whose acquired charging/discharging waveform does not satisfy the predetermined condition to be of bad quality. Thus, a user manufactures a secondary battery by using only sheet-type batteries 21 that are determined to be of good quality. That is, a secondary battery is completed by connecting sheet-type batteries 21 that are determined to be of good quality in parallel or in series. The sheet-type batteries 21 that are determined to be of bad quality are discarded or subjected to reexaminations etc.

In Fig. 1, the sheet-type battery 21 has a laminated structure in which an n-type oxide semiconductor layer 13, a charging layer 14, a p-type oxide semiconductor layer 16, and a second electrode 17 are laminated in this order on a substrate 11.

The substrate 11 is formed of a conductive material or the like, such a metal, and functions as a first electrode. In this embodiment, the substrate 11 serves as a negative electrode. As the substrate 11, for example, a metal foil sheet such as an aluminum sheet can be used.

It is also possible to prepare a substrate 11 made of an insulating material and form a first electrode on the substrate 11. That is, the substrate 11 may have any structure so long as it includes the first electrode. In the case of forming the first electrode on the substrate 11, a metal material such as chromium (Cr) or titanium (Ti) can be used as the material for the first electrode. As the material for the first electrode, an alloy film containing aluminum (Al), silver (Ag), etc. may also be used. In the case of forming the first electrode on the substrate 11, it can be formed in the same manner as the second electrode 17 is formed, which will be described later.

On the substrate 11, an n-type oxide semiconductor layer 13 is formed. The n-type oxide semiconductor layer 13 is formed so as to contain an n-type oxide semiconductor material (a second n-type oxide semiconductor material). As the n-type oxide semiconductor layer 13, it is possible to use, for example, a titanium dioxide (TiO₂), a tin oxide (SnO₂), a zinc oxide (ZnO), etc. For example, the n-type oxide semiconductor layer 13 can be formed on the substrate 11 by sputtering or vapor deposition. As the material for the n-type oxide semiconductor layer 13, a titanium dioxide (TiO₂) is preferably used.

On the n-type semiconductor layer 13, a charging layer 14 is formed. The charging layer 14 is formed of a mixture obtained by mixing an insulating material and an n-type oxide semiconductor material. For example, as an n-type oxide semiconductor material (a first n-type oxide semiconductor material) of the charging layer 14, fine particles of an n-type oxide semiconductor can be used. The n-type oxide semiconductor is subjected to a photo-excitation structure change by irradiation with ultraviolet light and thereby becomes a layer that has a charging function. As an insulating material of the charging layer 14, a silicone resin can be used. For example, as the insulating material, it is preferable to use a silicon compound (silicone) that has a main skeleton formed by siloxane bonding, such as a silicon oxide.

For example, the charging layer 14 is formed of an oxide silicone and a titanium dioxide, in which the titanium dioxide is used as the first n-type oxide semiconductor material. Besides the aforementioned material, a tin oxide (SnO₂) or a zinc oxide (ZnO) is preferred as the n-type oxide semiconductor material that can be used for the charging layer 14. It is also possible to use a material that is formed by combining two or all of a titanium dioxide, a tin oxide, and a zinc oxide.

A manufacturing process for the charging layer 14 is explained. First, a coating liquid is prepared by mixing a solvent with a mixture of a precursor of a titanium oxide, a tin oxide or a zinc oxide and silicone oil. A coating liquid is prepared by mixing fatty acid titanium and silicone oil in a solvent. Then, the coating liquid is applied on the n-type oxide semiconductor layer 13 by a spinning coating method or a slit coating method. A charging layer 14 can be formed on the n-type oxide semiconductor layer 13 by drying and calcining the coating film. Note that as an example of the precursor, titanium stearate, which is a precursor of a titanium oxide, can be used. The titanium oxide, the tin oxide, and the zinc oxide are formed by decomposing aliphatic acid salts, which are precursors of metal oxides. The charging layer 14, which has been dried and calcined, may be UV-cured by irradiation with UV (Ultra-Violet) light.

Note that for the titanium oxide, the tin oxide, the zinc oxide, etc., fine particles of oxide semiconductors may be used instead of using the precursors. A mixture solution is formed by mixing nanoparticles of a titanium oxide or a zinc oxide with silicone oil. Further, a coating liquid is formed by mixing a solvent in the mixture solution. The coating liquid is applied on the n-type oxide semiconductor layer 13 by a spinning coating method or a slit coating method. A charging layer 14 can be formed by performing drying, calcining, and UV irradiation on the coating film.

The material for the first n-type oxide semiconductor contained in the charging layer 14 and the material for the second n-type oxide semiconductor contained in the n-type oxide semiconductor layer 13 may be the same as each other or different from each other. For example, in the case where the material for the n-type oxide semiconductor contained in the n-type oxide semiconductor layer 13 is a tin oxide, the material for the n-type oxide semiconductor contained in the charging layer 14 may be the tin oxide or an n-type oxide semiconductor material other than the tin oxide.

On the charging layer 14, a p-type oxide semiconductor layer 16 is formed. The p-type oxide semiconductor layer 16 is formed so as to contain a p-type oxide semiconductor material. As a material for the p-type oxide semiconductor 16, it is possible to use a nickel oxide (NiO), a copper aluminum oxide (CuAlO₂), etc. For example, the p-type oxide semiconductor layer 16 is a nickel oxide film having a thickness of 400 nm. The p-type semiconductor layer 16 is formed on the charging layer 14 by a film formation method such as vapor deposition or sputtering.

The second electrode 17 should be formed of a conductive film. Further, as a material for the second electrode 17, a metal material such as chromium (Cr) or copper (Cu) can be used. Examples of other metal materials include a silver (Ag) alloy containing aluminum (Al). Examples of its formation method include vapor-phase film formation methods such as sputtering, ion plating, electron-beam vapor deposition, vacuum vapor deposition, and chemical vapor deposition. Further, the metal electrode can be formed by an electroplating method, an electro-less plating method, etc. As a metal used for the plating, generally, it is possible to use copper, a copper alloy, nickel, aluminum, silver, gold, zinc, tin, etc. For example, the second electrode 17 is an Al film having a thickness of 300 nm.

The sheet-type battery 21 may include other layers. The sheet-type battery 21 is a solid-state battery. The sheet-type battery 21 may also be called a unit battery. That it, a secondary battery is manufactured by combining a plurality of sheet-type batteries 21, each of which serves as a unit battery, with one another.

Note that in the explanation above, the n-type oxide semiconductor layer 13 is disposed below the charging layer 14 and the p-type oxide semiconductor layer 16 is disposed above the charging layer 14. However, the n-type oxide semiconductor layer 13 and the p-type oxide semiconductor layer 16 may be disposed the other way round. That is, the n-type oxide semiconductor layer 13 may be disposed above the charging layer 14 and the p-type oxide semiconductor layer 16 may be disposed below the charging layer 14. In this case, the substrate 11 serves as a positive electrode and the second electrode 17 serves as a negative electrode. That is, as long as the charging layer 14 is interposed between the n-type oxide semiconductor layer 13 and the p-type oxide semiconductor layer 16, either of the n-type oxide semiconductor layer 13 and the p-type oxide semiconductor layer 16 may be disposed above the charging layer 14. In other words, the sheet-type battery 21 may have any structure as long as the first electrode (the substrate 11), the first conductive oxide semiconductor layer (the n-type oxide semiconductor layer 13 or the p-type oxide semiconductor layer 16), the charging layer 14, the second conductive semiconductor layer (the p-type oxide semiconductor layer 16 or the n-type oxide semiconductor layer 13), and the second electrode 17 are laminated in this order.

Further, the sheet-type battery 21 may include a layer(s) other than the first electrode (the substrate 11), the first conductive oxide semiconductor layer (the n-type oxide semiconductor layer 13 or the p-type oxide semiconductor layer 16), the charging layer 14, the second conductive semiconductor layer (the p-type oxide semiconductor layer 16 or the n-type oxide semiconductor layer 13), and the second electrode 17.

Next, a configuration of the screening apparatus 50 connected to the sheet-type battery 21 is explained by referring to Figs. 1 and 2 again. The screening apparatus 50 includes a charger/discharger 61 and a personal computer (hereinafter referred to as a PC) 51. The PC 51 includes a charging/discharging waveform acquisition unit 52, a discharging voltage evaluation unit 53, a discharging time evaluation unit 54, a charging voltage evaluation unit 56, a charging efficiency evaluation unit 57, a current value evaluation unit 58, and a determination unit 59.

The charging/discharging waveform acquisition unit 52, the discharging voltage evaluation unit 53, the discharging time evaluation unit 54, the charging voltage evaluation unit 56, the charging efficiency evaluation unit 57, the current value evaluation unit 58, and the determination unit 59 can be implemented by the PC 51, which includes a CPU (Central Processing Unit), a recording medium such as a memory, an input device such as a keyboard, and a monitor etc. By executing a computer program stored in the memory, the PC 51 performs evaluation processes of the discharging voltage evaluation unit 53, the discharging time evaluation unit 54, the charging voltage evaluation unit 56, the charging efficiency evaluation unit 57, and the current value evaluation unit 58, and a determination process of the determination unit 59. These evaluation and determination processes will be described later.

The charger/discharger 61 charges and discharges the sheet-type battery 21. Specifically, the charger/discharger 61 charges the sheet-type battery 21 for a predetermined time in a CC-CV (Constant Current-Constant Voltage) manner, and then discharges the sheet-type battery 21 in a CC (Constant Current) manner. In the CC-CV charging, firstly, a constant-current charging is performed. Then, when the charging voltage reaches a predetermined voltage, the voltage is fixed at the predetermined voltage and hence constant-voltage charging is performed. In the CC method, discharging is performed with a constant current. The charger/discharger 61 controls and measures the voltage and the current during the charging and discharging.

The charging/discharging waveform acquisition unit 52 acquires a charging/discharging waveform in a charging/discharging test carried out by the charger/discharger 61. That is, the charging/discharging waveform acquisition unit 52 acquires a voltage waveform and a current waveform according to the voltage or the current measured during the charging and discharging. The charging/discharging waveform acquisition unit 52 associates the charging/discharging current and the charging/discharging voltage with the time and stores them in the memory etc. Note that the charger/discharger 61 may perform charging and discharging a plurality of times for one sheet-type battery 21. In such a case, the charging/discharging waveform acquisition unit 52 acquires a plurality of charging/discharging waveforms for one sheet-type battery 21.

The discharging voltage evaluation unit 53 evaluates the discharging voltage during the discharging. The discharging time evaluation unit 54 evaluates variations in discharging time in the charging/discharging waveform. The charging voltage evaluation unit 56 evaluates the charging voltage during the charging. The charging efficiency evaluation unit 57 evaluates charging efficiency based on the charging/discharging waveform. The current value evaluation unit 58 evaluates the current value at the end of the charging. The evaluations made by the discharging voltage evaluation unit 53, the discharging time evaluation unit 54, the charging voltage evaluation unit 56, the charging efficiency evaluation unit 57, and the current value evaluation unit 58 will be described later.

The determination unit 59 determines pass/fail of the sheet-type battery 21 based on the evaluations made by the charging voltage evaluation unit 53, the discharging time evaluation unit 54, the charging voltage evaluation unit 56, the charging efficiency evaluation unit 57, and the current value evaluation unit 58. That is, when satisfactory results are obtained for the evaluations of all of the discharging voltage, the discharging time, the charging voltage, the charging efficiency, and the current value at the end of the charging, the determination unit 59 determines that the sheet-type battery 21 is of good quality. Alternatively, when a satisfactory result is not obtained for the evaluation of at least one of the discharging voltage, the discharging time, the charging voltage, the charging efficiency, and the current value at the end of charging, the determination unit 59 determines that the sheet-type battery 21 is of bad quality. As described above, the screening apparatus 50 performs a screening of the sheet-type battery 21 based on the charging/discharging waveform acquired as described above.

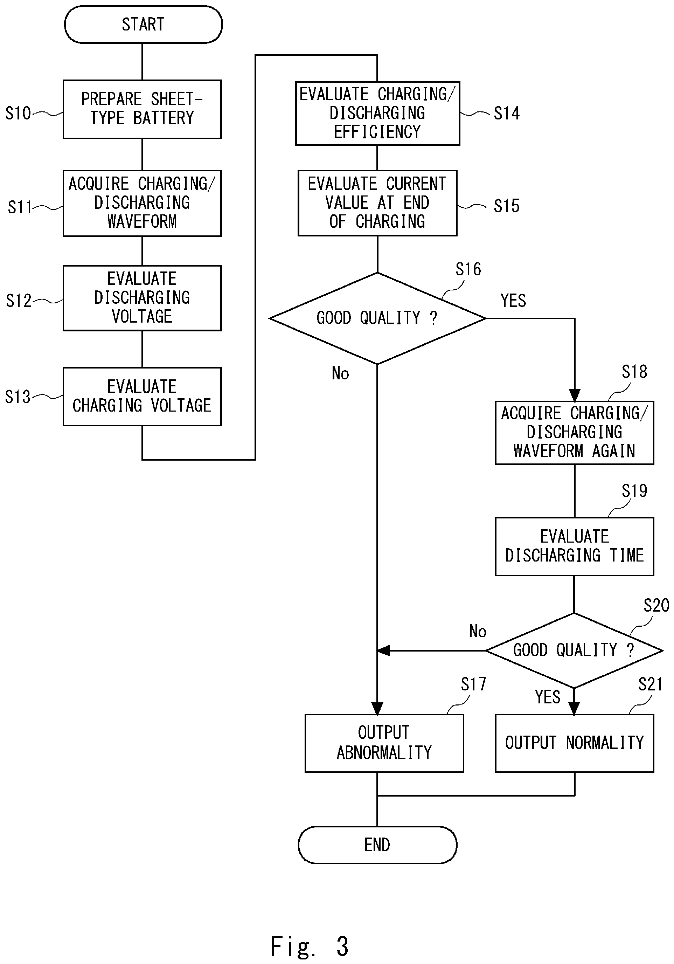

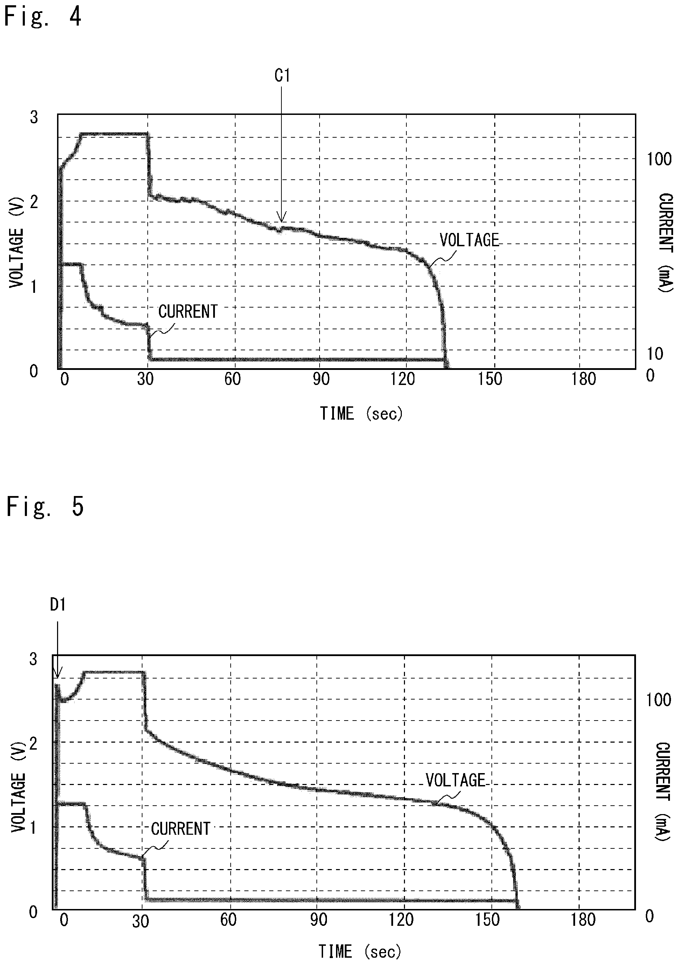

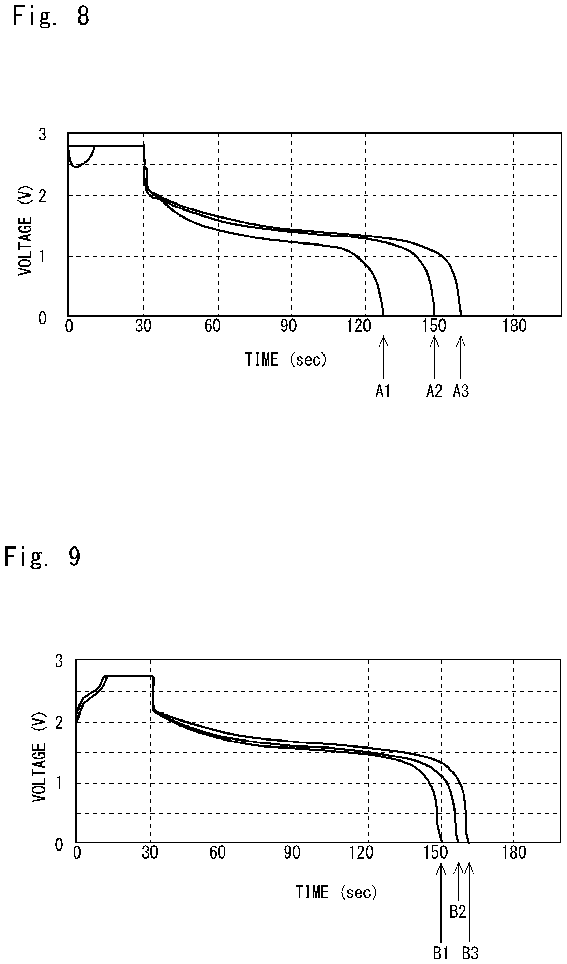

Next, a screening method performed by the screening apparatus 50 will be explained with reference to Figs. 3 to 9. Fig. 3 is a flowchart showing a screening method according to this embodiment. Figs. 4 to 9 are charging/discharging waveforms for explaining respective evaluations performed on the sheet-type battery 21. Figs. 4 to 7 show changes in charging/discharging voltages over time and changes in charging/discharging currents over time. Figs. 8 and 9 show changes in charging/discharging voltages over time.

As described above, the charger/discharger 61 first performs CC-CV charging for the sheet-type battery 21 for a predetermined time and then performs CC discharging. For example, when the charger/discharger 61 performs charging/discharging, i.e., performs a set of CC-CV charging and CC discharging, the charging/discharging waveform acquisition unit 52 acquires one sheet of charging/discharging waveforms (see S11 in the below-described flowchart)

For example, the charger/discharger 61 can charge the sheet-type battery 21 for a charging time of 30 seconds under a charging setting of 2.7 V and 50 mA. In this case, the charger/discharger 61 charges the sheet-type battery 21 with the constant current of 50 mA until its voltage reaches 2.7 V, and when the voltage of the sheet-type battery reaches 2.7 V, the charger/discharger 61 reduces the current and charges the sheet-type battery 21 at the constant voltage of 2.7 V. In the discharging, the charger/discharger 61 discharges the sheet-type battery 21 at a constant current until its battery remaining amount becomes 0%.

First, the sheet-type battery 21 is prepared (S10). Specifically, in the step S10, a plurality of sheet-type batteries 21 each having a laminated structure shown in Fig. 1 or like are prepared. Next, the charger/discharger 61 carries out a charging/discharging test for each sheet-type battery 21 and the charging/discharging waveform acquisition unit 52 acquires a charging/discharging waveform of the sheet-type battery 21 (S11). Specifically, in the step S11, the charger/discharger 61 performs charging and discharging once for one sheet-type battery 21. By doing so, the charging/discharging waveform acquisition unit 52 acquires one charging/discharging waveform for one sheet-type battery 21. For example, assume that a voltage value and a current value are acquired every one second in each charging/discharging waveform.

Next, the discharging voltage evaluation unit 53 evaluates changes in discharging voltage over time during the discharging (S12). In the step S12, the discharging voltage evaluation unit 53 evaluates whether or not the voltage has risen during the discharging. Fig. 4 shows a charging/discharging waveform that includes a rise in the discharging voltage. In Fig. 4, the voltage rises at a point C1 during the discharging.

Specifically, in the step S12, the discharging voltage evaluation unit 53 compares voltage values at different timings with one another during the discharging and, based on the result of the comparison, evaluates whether or not there is a rise in the discharging voltage. That is, the discharging voltage evaluation unit 53 detects presence/absence of an abnormality based on the behavior of the discharging voltage.

The discharging voltage evaluation unit 53 evaluates variations in discharging voltage over time based on whether or not the variations in discharging voltage over time are equal to or higher than a predetermined discharging voltage threshold (hereinafter referred to as a discharging voltage threshold Vth1). Specifically, for example, a differential value (V2-V1) between a voltage value at an arbitrary timing (hereinafter referred to as a voltage value V2) and a voltage value at a timing immediately before the arbitrary timing (hereinafter referred to as a voltage value V1) during the discharging corresponds to a variation in discharging voltage over time. When the differential value (V2-V1) of the discharging voltage is equal to or higher than the discharging voltage threshold Vth1, the discharging voltage evaluation unit 53 determines that the discharging voltage has risen. On the other hand, when the differential value (V2-V1) between the two voltage values V2 and V1 is lower than the discharging voltage threshold Vth1, the discharging voltage evaluation unit 53 determines that the discharging voltage has not risen. In this manner, the discharging voltage evaluation unit 53 evaluates the variation in discharging voltage over time based on the differential value between discharging voltages at two consecutive timings.

The discharging voltage evaluation unit 53 determines that the voltage has risen during the discharging when there is at least one point at which the differential value (V2-V1) is equal to or higher than the discharging voltage threshold Vth1 during the discharging. In Fig. 4, for example, the discharging voltage has risen at the point C1. As described above, the discharging voltage evaluation unit 53 detects presence/absence of an abnormality based on the result of the comparison between the differential value (V2-V1) and the discharging voltage threshold Vth1. Note that the discharging voltage threshold Vth1 is a positive value and can be set to, for example, 0.02 V.

Next, the charging voltage evaluation unit 56 evaluates changes in charging voltage overtime during the charging of the sheet-type battery 21 (S13). Specifically, the charging voltage evaluation unit 56 evaluates whether or not the voltage has dropped during the charging. Fig. 5 shows a charging/discharging waveform that includes a drop in the charging voltage. In Fig. 5, the voltage drops at a point D1 during the charging. The charging voltage evaluation unit 56 compares voltage values at different timings with one another during the charging and, based on the result of the comparison, evaluates whether or not there is a drop in the charging voltage. That is, the charging voltage evaluation unit 56 detects presence/absence of an abnormality based on the behavior of the charging voltage.

The charging voltage evaluation unit 56 evaluates variations in charging voltage over time based on whether or not the variations in charging voltage over time are equal to or higher than a charging voltage threshold Vth2. Specifically, for example, a differential value (V3-V4) between a voltage value at an arbitrary timing (hereinafter referred to as a voltage value V3) and a voltage value at a timing immediately after the arbitrary timing (hereinafter referred to as a voltage value V4) during the charging corresponds to a variation in charging voltage over time. When the differential value (V3-V4) of the charging voltage is equal to or higher than the charging voltage threshold (hereinafter referred to as a charging voltage threshold Vth2), the charging voltage evaluation unit 56 determines that the charging voltage has dropped. On the other hand, when the differential value (V3-V4) of the two voltage values V3 and V4 is lower than the charging voltage threshold Vth2, the charging voltage evaluation unit 56 determines that the charging voltage has not dropped. As described above, the charging voltage evaluation unit 56 evaluates the change in charging voltage over time during the charging based on the differential value between charging voltages at two consecutive timings.

The charging voltage evaluation unit 56 determines that the voltage has dropped during the charging when there is at least one point at which the value (V3-V4) is equal to or higher than the charging voltage threshold Vth2 during the charging. In Fig. 5, for example, the charging voltage has dripped at the point D1. As described above, the charging voltage evaluation unit 56 detects presence/absence of an abnormality based on the result of the comparison between the differential value (V3-V4) and the charging voltage threshold Vth2. Note that the charging voltage threshold Vth2 is a positive value and can be set to, for example, 0.1 V.

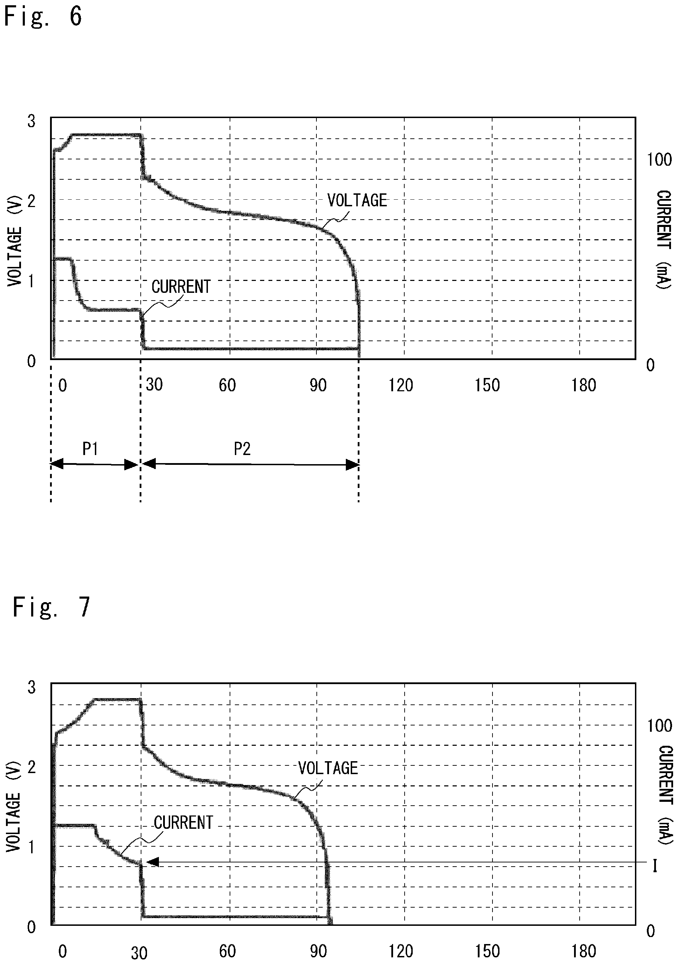

Next, the charging efficiency evaluation unit 57 evaluates charging efficiency based on the charging/discharging waveform (S14). Then, the charging efficiency evaluation unit 57 determines whether the charging efficiency of the sheet-type battery 21 is higher or lower than an efficiency threshold. Next, a method for calculating charging efficiency will be described in detail with reference to Fig. 6.

### <Electric Energy Required for Charging>

A product of a charging voltage and a charging current at each timing is charged electric power. Further, a value obtained by integrating the charged electric power with respect to the time over a charging period (over a charging period P1 in Fig. 6) is electric energy required for the charging.

### <Electric Energy Obtained by Charging>

A product of a discharging voltage and a discharging current at each timing is the discharged electric power. Further, a value obtained by integrating the discharged electric power with respect to the time over a discharging period (over a discharging period P2 in Fig. 6) is electric energy obtained by the discharging.

### <Charging Efficiency>

Charging efficiency is calculated by an expression "(Electric Energy Obtained by Discharging)/(Electric Energy Required for Charging)".

The charging efficiency evaluation unit 57 calculates charging efficiency E by obtaining electric energy calculated from the electric energy required for the charging and the electric energy obtained by the discharging based on the charging/discharging waveform as described above. Then, the charging efficiency evaluation unit 57 compares the calculated charging efficiency with an efficiency threshold Eth. The charging efficiency evaluation unit 57 determines that the charging efficiency is high when the charging efficiency E is equal to or higher than the efficiency threshold Eth, and determines that the charging efficiency is low when the charging efficiency E is lower than the efficiency threshold Eth. The efficiency threshold Eth can be set to, for example, 80%. The charging efficiency evaluation unit 57 detects presence/absence of an abnormality based on the charging efficiency.

Next, the current value evaluation unit 58 evaluates a current value at the end of the charging based on the charging/discharging waveform (S15). For example, in the case where the charging time is 30 seconds, the current value evaluation unit 58 acquires a charging current value 30 seconds after the start of the charging as a current value I at the end of the charging (see Fig. 7). That is, the current value I at the end of the charging is a current value that is acquired at the last timing of the constant-voltage charging. Then, the current value evaluation unit 58 compares the current value I with a current threshold Ith, and determines that the current value I is normal when it is equal to or smaller than the current threshold Ith and determines that the current value I is abnormal when it is larger than the current threshold Ith. As described above, the current value evaluation unit 58 detects presence/absence of an abnormality based on the result of the comparison between the current value I and the current threshold Ith.

Next, the determination unit 59 determines whether or not the sheet-type battery is of good quality based on the above-described evaluation results (S16). Specifically, the determination unit 59 determines a sheet-type battery for which an abnormality is detected in at least one of the items evaluated by the discharging voltage evaluation unit 53, the discharging time evaluation unit 54, the charging voltage evaluation unit 56, the charging efficiency evaluation unit 57, and the current value evaluation unit 58 to be of bad quality ("No" in S16). Then, the screening apparatus 50 outputs information that the sheet-type battery is abnormal on a monitor screen of the PC (S17). After outputting the abnormality, the process is finished.

The determination unit 59 determines a sheet-type battery 21 that has passed all of the items evaluated by the discharging voltage evaluation unit 53, the discharging time evaluation unit 54, the charging voltage evaluation unit 56, the charging efficiency evaluation unit 57 and the current value evaluation unit 58 to be of good quality ("Yes" in S16).

When the sheet-type battery is determined to be of good quality in the step S16, the charging/discharging waveform acquisition unit 52 acquires a charging/discharging waveform again (S18). Here, similarly to the step S12, the charger/discharger 61 performs CC-CV charging and CC discharging, and the charging/discharging waveform acquisition unit 52 acquires a charging/discharging waveform. In this way, a second charging/discharging waveform is acquired for the sheet-type battery 21. Through the steps S11 and S18, a plurality of charging/discharging waveforms are acquired for one sheet-type battery 21. In the step S18, the charging/discharging waveform acquisition unit 52 may acquire a plurality of charging/discharging waveforms.

The discharging time evaluation unit 54 evaluates a discharging time in the charging/discharging waveform (S19). Specifically, the discharging time evaluation unit 54 calculates discharging times for the plurality of charging/discharging waveforms acquired in the steps S11 and S18. Then, the discharging time evaluation unit 54 evaluates variations in discharging time among plurality of charging/discharging waveforms for one sheet-type battery 21.

The evaluation made by the discharging time evaluation unit 54 will be described with reference to Figs. 8 and 9. Fig. 8 shows voltage waveforms in the case where variations in discharging time is large, and Fig. 9 shows voltage waveforms in the case where variations in discharging time is small. Each of Figs. 8 and 9 shows three charging/discharging waveforms. A sheet-type battery 21 for which the charging/discharging waveforms shown in Fig. 8 are acquired is referred to as a sample A, and a sheet-type battery 21 for which the charging/discharging waveforms shown in Fig. 9 are acquired is referred to as a sample B. The samples A and B are different samples (different sheet-type batteries 21).

Discharging times in the three charging/discharging waveforms shown in Fig. 8 are represented by A1 to A3, and three discharging times shown Fig. 9 are represented by B1 to B3. Note that each of the discharging times A1 to A3 and the discharging times B1 to B3 corresponds to a time at which the discharging has ended, i.e., a time at which the battery remaining amount has become 0% because of the discharging. That is, the time at which the voltage has become 0 V because of the CC discharging is defined as the time at which the discharging has ended.

Since differences among the discharging times A1 to A3 are large, the discharging time evaluation unit 54 evaluates the sample A as a unit battery that has large variations in discharging time. Since differences among the discharging times B1 to B3 are small, the discharging time evaluation unit 54 evaluates the sample B as a unit battery that has small variations in discharging time. Note that for the evaluation of variations in discharging time, a difference between the maximum discharging time and the minimum discharging time, or a standard deviation of discharging times may be used. The discharging time evaluation unit 54 detects presence/absence of an abnormality based on the variations in discharging time.

Then, the determination unit 59 determines whether or not the sheet-type battery is of good quality based on the discharging time (S20). The determination unit 59 determines a sheet-type battery 21 that has large variations in discharging time to be of bad quality ("No" in S20). The screening apparatus 50 outputs information that the sheet-type battery is abnormal on the monitor screen of the PC (S17). After outputting the abnormality, the process is finished. The determination unit 59 determines that the sheet-type battery 21 that has small variation in discharging time to be of good quality ("Yes" in S20). Then, the screening apparatus 50 outputs information that the sheet-type battery is normal on the monitor screen of the PC (S21). After outputting the normality, the process is finished.

As described above, the discharging voltage evaluation unit 53, the discharging time evaluation unit 54, the charging voltage evaluation unit 56, the charging efficiency evaluation unit 57, and the current value evaluation unit 58 detect an abnormality in the charging/discharging waveforms. Then, the determination unit 59 determines the sheet-type battery (the unit battery) 21 for which an abnormal charging/discharging waveform is obtained to be of bad quality. By doing so, pass/fail of the sheet-type battery can be appropriately determined. That is, the sheet-type battery 21 for which there is an irregularity in the charging efficiency, the charging waveform, or the discharging waveform can be appropriately excluded. Since the sheet-type battery 21 is screened based on the four items, the screening can be appropriately performed.

Further, a charging/discharging waveform is acquired again in the step S18 for the sheet-type battery 21 for which the evaluations made by the discharging voltage evaluation unit 53, the charging voltage evaluation unit 56, the charging efficiency evaluation unit 57, and the current evaluation unit 58 have been satisfactory. In other words, a charging/discharging waveform is not acquired again for the sheet-type battery 21 for which at least one evaluation item is unsatisfactory. Accordingly, it is possible to avoid unnecessary charging/discharging tests and thereby to perform screening more efficiently. Needless to say, it is possible to acquire a plurality of charging/discharging waveforms in the S11, and thereby to perform the evaluation by the discharging time evaluation unit 54 together with the evaluations performed by the discharging voltage evaluation unit 53, the charging voltage evaluation unit 56, the charging efficiency evaluation unit 57, and the current value evaluation unit 58.

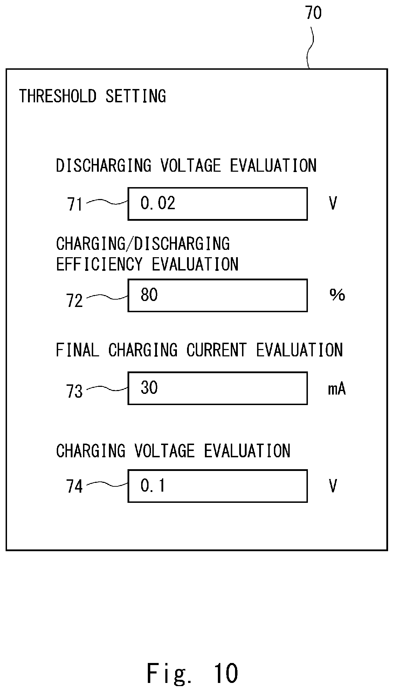

Note that the discharging voltage threshold Vth1, the charging voltage threshold Vth2, the efficiency threshold Eth, and the current threshold Ith may be set by a user. For example, the screening device 50 displays a setting window 70 shown in Fig. 10 on the monitor. Then, a user enters each of the thresholds by using an input device such as a keyboard, a mouse, etc.

For example, in an input field 71, 0.02 V is entered as the charging voltage threshold Vth1. In an input field 72, 80% is entered as the efficiency threshold Eth. In an input field 73, 30 mA is entered as the current threshold Ith. In an input field 74, 0.1 V is entered as the charging voltage threshold. The screening apparatus 50 reads the values entered by the user and sets them as the thresholds. Then, pass/fail of sheet-type batteries is determined based on the thresholds. Needless to say, the aforementioned current value, the voltage value, the efficiency value, etc. are mere examples, and they should not be limited to the aforementioned values. For example, appropriate thresholds can be set according to the size and the laminated structure of the sheet-type battery 21.

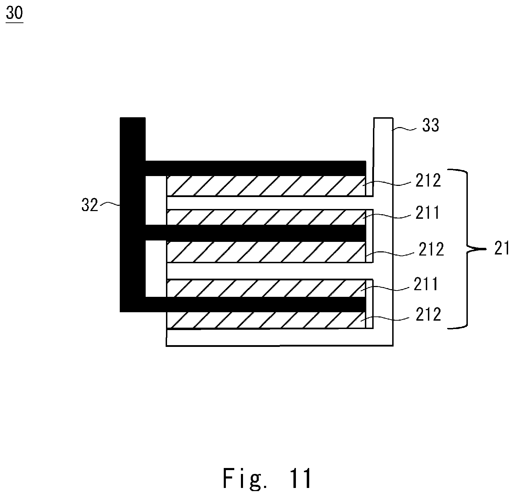

Then, a user manufactures a secondary battery by using only sheet-type batteries 21 that have been selected as conforming items. That is, the user excludes sheet-type batteries 21 that have been determined to be of bad quality. A plurality of sheet-type batteries 21 having good quality are connected to one another. Fig. 11 is a cross section schematically showing a secondary battery 30 including five sheet-type batteries (five unit batteries) 21. The secondary battery 30 is a cell sheet in which a plurality of sheet-type batteries 21 are laminated.

In Fig. 11, each of the sheet-type batteries 21 is shown as a unit battery 211 or a unit battery 212. Among the plurality of sheet-type batteries 21, those under which substrates 11 are disposed and over which second electrodes 17 are disposed are shown as unit batteries 211. Further, among the plurality of sheet-type batteries 21, those over which the substrates 11 are disposed and under which the second electrodes 17 are disposed are shown as unit batteries 212.

The secondary battery 30 includes a negative terminal 32 and a positive terminal 33. The plurality of sheet-type batteries 21 are connected in parallel through the negative terminal 32 and the positive terminal 33. The negative terminal 32 is connected to each of the substrates (negative electrodes) 11 of the sheet-type batteries 21. The positive terminal 33 is connected to each of the second electrodes (positive electrodes) 17 of the sheet-type batteries 21. Further, the unit batteries 211 and 212 are alternately laminated. The positive terminal 33 is disposed between the second electrodes 17 of the unit batteries 211 and the second electrodes 17 of the unit batteries 212. The negative terminal 32 is disposed between the substrates 11 of the unit batteries 211 and the substrates 11 of the unit batteries 212.

Among the laminated unit batteries 211 and 212, for those located on the outermost layers (the uppermost layer and the lowermost layer in Fig. 11), when the substrate 11 is located on the outer side, the negative terminal 32 is laminated thereon. Further, when the second electrode 17 is located on the outer side, the positive terminal 33 is laminated thereon. The positive terminal 33 and the negative terminal 32 are connected to a charging apparatus when the secondary battery is charged. Further, they are connected to an electric appliance that acts as a load when the secondary battery is discharged (when the secondary battery is used).

Fig. 11 shows the secondary battery 30 including five sheet-type batteries 21. However, the secondary battery 30 may include six or more sheet-type batteries 21, or may include at least two or four sheet-type batteries 21. That is, in the secondary battery 30, a plurality of sheet-type batteries 21 are connected in parallel. As described above, it is possible to manufacture a secondary battery 30 having a large capacity by connecting a plurality of sheet-type batteries 21. Needless to say, each of the terminals is not limited to the structure shown in Fig. 11.

In the method for manufacturing a secondary battery 30 according to this embodiment, the secondary battery 30 is manufactured by laminating sheet-type batteries that have been evaluated to be of good quality in the above-described screening method. That is, the secondary battery 30 is manufactured by connecting only sheet-type batteries 21 having good quality with one another. As a result, each of the sheet-type batteries 21 constituting the secondary battery 30 has no abnormality in any of all the evaluation items. That is, the secondary battery 30 is formed by using sheet-type batteries 21 having no abnormality in any of the evaluations of the charging voltage, the discharging voltage, the charging efficiency, the charging current, and the discharging time. Therefore, it is possible to manufacture a secondary battery 30 that does not include unit batteries (sheet-type batteries 21) having variations in performance among them.

By doing so, it is possible to improve the yield of secondary batteries 30. Therefore, it is possible to manufacture high-performance secondary batteries 30 with high productivity. It is possible to manufacture stable secondary batteries 30. Further, screenings are performed by combining a plurality of evaluation conditions. Therefore, it is possible to appropriately set thresholds for evaluations

Note that the evaluation by the discharging time evaluation unit 54 is not indispensable. That is, the determining unit 59 may make a pass/fail determination based on at least four evaluation items, i.e., based on the evaluations of the discharging voltage evaluation unit 53, the charging voltage evaluation unit 56, the charging efficiency evaluation unit 57, and the current value evaluation unit 58. In the case where the evaluation by the discharging time evaluation unit 54 is not performed, the charging/discharging test may be carried out only once for one sheet-type battery (one unit battery) 21. In this case, the steps S18 to S20 can be skipped. There is no particular limitation on the order of the evaluations by the discharging voltage evaluation unit 53, the charging voltage evaluation unit 56, the charging efficiency evaluation unit 57, and the current value evaluation unit 58. For example, the order of steps S12 to S15 in Fig. 3 may be interchanged with one another. Further, two or more of these steps may be performed in parallel.

In the explanation above, the screening apparatus 50 performs a screening under the assumption that one sheet-type battery 21 is used as one unit battery. However, the unit battery is not limited to the sheet-type battery 21. For example, a cell sheet in which a plurality of sheet-type batteries 21 are laminated can be used as a unit battery.

Although the embodiments according to the present disclosure have been explained above, the present disclosure also includes various modifications that do not substantially impair the purposes and the advantages of the present disclosure. Further, the above-described embodiments should not be used to limit the scope of the present disclosure.

This application is based upon and claims the benefit of priority from Japanese patent application No. 2016-232479 filed on November 30, 2016, the disclosure of which is incorporated herein in its entirety by reference.

### Reference Signs List

- 11: SUBSTRATE (FIRST ELECTRODE)
- 13: n-TYPE OXIDE SEMICONDUCTOR LAYER
- 14: CHARGING LAYER
- 16: p-TYPE OXIDE SEMICONDUCTOR LAYER
- 17: SECOND ELECTRODE
- 21: SHEET-TYPE BATTERY
- 30: SECONDARY BATTERY
- 32: NEGATIVE TERMINAL
- 33: POSITIVE TERMINAL
- 50: SCREENING APPARATUS
- 51: PC
- 52: CHARGING/DISCHARGING WAVEFORM ACQUISITION UNIT
- 53: DISCHARGING VOLTAGE EVALUATION UNIT
- 54: DISCHARGING TIME EVALUATION UNIT
- 56: CHARGING VOLTAGE EVALUATION UNIT
- 57: CHARGING EFFICIENCY EVALUATION UNIT
- 58: CURRENT VALUE EVALUATION UNIT
- 59: DETERMINATION UNIT
- 61: CHARGER/DISCHARGER

## Claims

1. A screening method for screening a unit battery, comprising:
a charging/discharging waveform acquisition step of acquiring a charging/discharging waveform of the unit battery by charging and discharging the unit battery;
a first step of evaluating a variation in discharging voltage over time during discharging in the unit battery based on the charging/discharging waveform;
a second step of evaluating a variation in charging voltage over time during charging in the unit battery based on the charging/discharging waveform;
a third step of evaluating charging efficiency of the unit battery based on the charging/discharging waveform;
a fourth step of evaluating a current value at an end of the charging of the unit battery based on the charging/discharging waveform; and
a screening step of screening the unit battery based on evaluation results of the first, second, third and fourth steps.

2. The screening method according to Claim 1, wherein in the charging/discharging waveform acquisition step, the charging/discharging waveform is acquired by charging the unit battery for a predetermined time in a CC-CV (Constant Current-Constant Voltage) manner and then discharging the unit battery in a CC (Constant Current) manner.

3. The screening method according to Claim 1 or 2, wherein in the first step, the variation in discharging voltage over time during the discharging is evaluated based on whether or not the variation in discharging voltage over time is equal to or higher than a predetermined discharging voltage threshold.

4. The screening method according to any one of Claims 1 to 3, wherein in the second step, the variation in charging voltage over time during the charging is evaluated based on whether or not the variation in charging voltage over time is equal to or higher than a predetermined charging voltage threshold.

5. The screening method according to any one of Claims 1 to 4, wherein in the fourth step, the current value at the end of the charging is evaluated based on whether or not the current value at the end of the charging is equal to or higher than a predetermined current threshold.

6. The screening method according to any one of Claims 1 to 5, wherein
the charging/discharging waveform is acquired again for the unit battery for which the evaluations in the first, second, third and fourth steps are satisfactory,
a variation in discharging time among a plurality of charging/discharging waveforms for the unit battery is evaluated, and
the unit battery is screened based on a result of the evaluation of the variation in discharging time.

7. A method for manufacturing a secondary battery, in which the secondary battery is manufactured by connecting a plurality of unit batteries with one another, the plurality of unit batteries being screened by a screening method according to any one of Claims 1 to 6.

8. A screening apparatus configured to screen a unit battery, comprising:
a charger/discharger configured to charge and discharge the unit battery;
a charging/discharging waveform acquisition unit configured to acquire a charging/discharging waveform of the unit battery by charging and discharging the unit battery by the charger/discharger;
a discharging voltage evaluation unit configured to evaluate a variation in discharging voltage over time during discharging in the unit battery based on the charging/discharging waveform;
a charging voltage evaluation unit configured to evaluate a variation in charging voltage over time during charging in the unit battery based on the charging/discharging waveform;
a charging efficiency evaluation unit configured to evaluate charging efficiency of the unit battery based on the charging/discharging waveform; and
a current value evaluation unit configured to evaluate a current value at an end of the charging of the unit battery based on the charging/discharging waveform.

9. The screening apparatus according to Claim 8, wherein the charging/discharging waveform acquisition unit acquires the charging/discharging waveform by charging, by the charger/discharger, the unit battery for a predetermined time in a CC-CV manner and then discharging the unit battery in a CC manner.

10. The screening apparatus according to Claim 8 or 9, wherein the discharging voltage evaluation unit evaluates the variation in discharging voltage over time during the discharging based on whether or not the variation in discharging voltage over time is equal to or higher than a predetermined discharging voltage threshold.

11. The screening apparatus according to any one of Claims 8 to 10, wherein the charging voltage evaluation unit evaluates the variation in charging voltage during the charging over time based on whether or not the variation in charging voltage over time is equal to or higher than a predetermined charging voltage threshold.

12. The screening apparatus according to any one of Claims 8 to 11, wherein the current value evaluation unit evaluates the current value at the end of the charging based on whether or not the current value at the end of the charging is equal to or higher than a predetermined current threshold.

13. The screening apparatus according to any one of Claims 8 to 12, wherein
for the unit battery for which the evaluations in the discharging voltage evaluation unit, the charging voltage evaluation unit, the charging efficiency evaluation unit, and the current value evaluation unit are satisfactory, the charging/discharging waveform acquisition unit acquires the charging/discharging waveform again by charging and discharging, by the charger/discharger, that unit battery,
a variation in discharging time among a plurality of charging/discharging waveforms for the unit battery is evaluated, and
the unit battery is screened based on a result of the evaluation of the variation in discharging time.
